# EUROPEAN PATENT APPLICATION

(11) **EP 1 076 110 A1**
(43) Date of publication of application: **14.02.2001**
(21) Application number: 00306918.4
(22) Date of filing: 14.08.2000
(51) Int. Cl.: C23C 14/35, C23C 14/54, H01L 21/00, H01J 37/34

(54) **Cooling gas used with a self-sputtering method**

(30) Priority: 12.08.1999 US 373490
(71) Applicant: Applied Materials, Inc., Santa Clara, California 95054-3299 (US)
(72) Inventor: Fu, Jianming, San Jose, California 95124 (US)
(74) Representative: Cross, Rupert Edward Blount

(57) **Abstract**

A plasma sputtering reactor (10), particularly one designed for sustained self-sputtering of copper or for low-pressure sputtering, in which the pedestal (16) supporting the wafer (18) to be sputter deposited includes backside cooling or heating of the wafer through a thermal transfer gas (60), the thermal transfer gas being helium. Argon (24) is supplied to strike the plasma (38) and may be additionally supplied during operation for low-pressure sputtering.

## Description

The invention relates generally to plasma sputtering in semiconductor processing. In particular, the invention relates to the backside cooling gas used with low-pressure sputtering or sustained self-sputtering.

Modern semiconductor integrated circuits typically include several levels of metallization used to form horizontal interconnects between devices spaced across the wafer. In the past, aluminum has been the typical metal used for the metallization although it is typically alloyed with a few per cent of silicon or copper to reduce electromigration. Recently however, copper has begun to be used for the metallization. Copper offers lower resistivity and much reduced electromigration. Other metals such as titanium and tantalum are also frequently used in the metallization process, often as barrier or wetting layers.

Sputtering, alternatively called physical vapor deposition (PVD) is the most widely used technique in depositing these metals on silicon or glass substrates during semiconductor processing to form semiconductor integrated circuits.

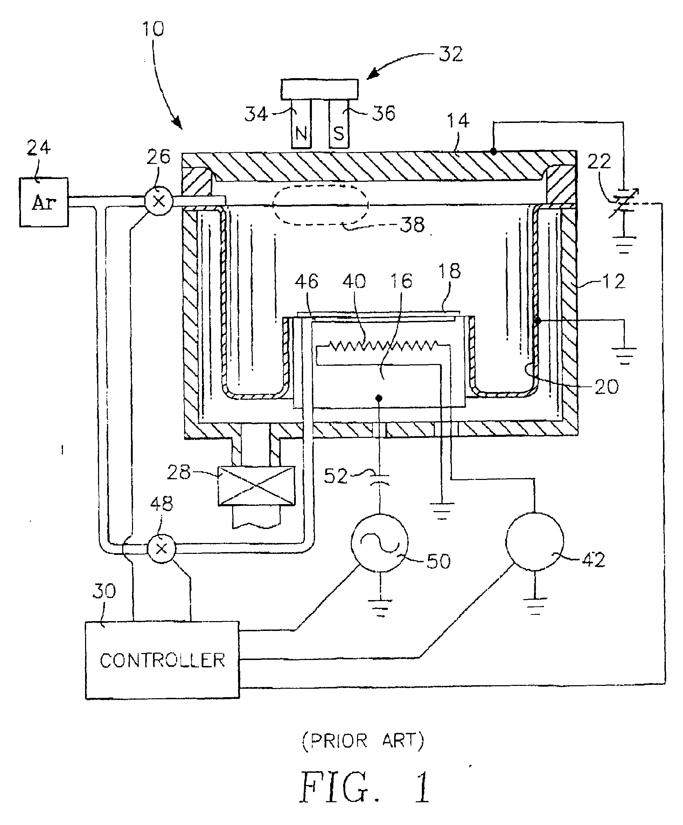

A prior-art plasma sputtering reactor 10 is illustrated schematically, partially in cross section, in FIG. 1. It includes a vacuum chamber 12 having a target 14 sealed to its roof. The target 14 is composed of the metal to be sputter deposited, for example, an aluminum alloy or copper. A pedestal 16 supporting a wafer 18 to be sputter coated is opposed to the target 14. A shield 20 is positioned around the pedestal 16 and inside the walls of the chamber 12 so as to protect them from being coated with the sputtered material. Instead, the shield 20 is periodically replaced or cleaned as the sputtered material builds up to thicknesses which would tend to flake off, a source of harmful particles.

Typically the shield 20 is electrically grounded while a DC power supply 22 negatively biases the target 14 to about -600VDC. RF plasma sputtering is known but is not a usual commercial process.
Additional power may be supplied from an RF inductive coil wound around the chamber, but this configuration will not be further discussed.

A plasma working gas, typically argon, is supplied from a gas source 24 through a mass flow controller 26 into the plasma chamber. A vacuum system 28 maintains the gas pressure within the chamber in a range typically between 1 and 100 milliTorr. A controller 30 controls the various power supplies and valves used as operational parameters for sputtering.

The negative voltage applied between the target 14 and the shield 20 is sufficient at these pressures to cause the working gas to electrically discharge into a plasma of positive gas ions and negative electrons. To intensify the plasma, a magnetron 32 is placed at the back of the target 14. It has opposed magnetic poles 34, 36 which create an adjacent magnetic field inside the chamber. The magnetic field traps light electrons, and positively charged ions migrate to the same region 38 to maintain charge neutrality, thus creating a higher-density plasma. The magnetron 32 is usually rotated about the back of the target to increase the sputtering uniformity.

The positive ions in the plasma are attracted to the negatively biased target 14 with sufficient kinetic energy and momentum that the ions sputter the material of the target 14 into atoms or atomically sized particles. The momentum depends primarily on the mass of the ion, its charge state which is usually singly ionized positive, and the voltage drop across the plasma sheath adjacent to the target 14. The sputtered particles ejected from the target 14 typically travel ballistically with a wide angular distribution, but a significant number of them arrive at the wafer 18 and are deposited on the surface of the wafer 18 as a metal layer having the same composition as the target 14. Reactive sputtering is also possible in which an additional gas such as nitrogen is admitted in the sputter chamber to react with the sputtered metal atoms to form a metal nitride layer on the wafer 18. The sputter deposition of TiN, TaN, or WN may be performed in this manner. Reactive sputtering will not be further discussed.

For semiconductor processing, the usual working gas is argon, although mixtures of argon and lighter noble gases have been suggested, for example, by Leiphart in U.S. Patent 5,667,645. A noble gas is desired for the working gas because it is chemically inactive and will not react with the sputtered metal ions. Even if atoms of the noble gas are embedded in the sputter deposited layer, they seem to not deleteriously affect the metal. Only two noble gases are commonly available at reasonable cost, helium and argon. Of these two, argon is greatly preferred because sputtering is a kinetic process, and argon is heavier than helium by about a factor of ten. The difference in atomic mass means that in DC sputtering ionized argon is arriving at the target with higher momentum than is ionized helium. Furthermore, the heavier argon has a lower ionization potential, facilitating the ignition and support of the plasma of the working gas.

The temperature of the wafer 18 during sputter coating needs to be controlled. Sometimes, a somewhat higher temperature of, for example, 150°C is desired to assure a fine texture in sputter deposited aluminum. Furthermore, sputtering is used to fill metal into via holes extending between metallization levels. In advanced circuits, these holes can be narrow and deep, having aspect ratios of 3 and higher. The sputtering process is itself predominately isotropic, with the angular sputter distribution typically varying with the cosine of the angle from the perpendicular. Sputter filling such deep holes is a problem. Several techniques rely upon warm deposition of aluminum, for example, around 350°C, or even hot deposition, for example, up to 500°C, so that the sputtered aluminum tends to flow from the top of the hole to the bottom even during deposition with the formation of included voids. However, it is desired to closely limit the temperature since a strict thermal budget is usually set for the entire fabrication sequence. Excessive exposure to high temperatures may cause undesired diffusion or oxidation in the already deposited layers, which may degrade the device performance or introduce reliability problems.

High-density plasma sputtering, which may be used instead of hot sputtering, may produce great amounts of heat, resulting in excessively high temperatures at the wafer 40. In these cases, a cooling fluid may flow through unillustrated fluid channels extend through the pedestal 16 to maintain a desired temperature at the wafer 18. Furthermore, for other applications, such as copper sputtering, a lower temperature of -30 to -50°C is desired to promote a smooth coating. In either case of cooling or heating, close temperature control of the wafer is required.

For these reasons, the sputter pedestal 16 typically includes a resistive heater 40, schematically illustrated in FIG. 1, embedded in but electrically isolated from the aluminum pedestal 16 and which is controllably powered by heater power supply 42. In practice, the resistive heater 40 is formed along a spiral path. The pedestal 16 may include additionally or alternatively an unillustrated fluid channel for flowing a chilling liquid of chilled water or a low-temperature refrigerant. The temperature regulation typically depends upon an unillustrated thermocouple in the pedestal allowing the controller 30 to monitor the temperature and to accordingly adjust the heater power supply 42 or the pump for the chilling water to bring the temperature into a preset range.

However, absent additional means, the active temperature control of the heater 40 or cooling channels tends to be ineffective inside a plasma sputtering chamber because of the low operational chamber pressures, typically 1 to 100 milliTorr. At these pressures, convective heat transfer between the pedestal 16 and the wafer is almost non-existent, whether for heating or cooling. Conductive heat transfer is uncertain, especially since the front of the wafer 16 needs to remain exposed and cannot be pressed firmly against the pedestal 18. Generally, radiative heat transfer is not effective at the relatively low temperatures and temperature differentials experienced in sputtering for semiconductor processing. For these reasons, backside gas cooling is typically used in semiconductor sputtering as well as other forms of semiconductor processing such as plasma etching and chemical vapor deposition (CVD). In backside gas cooling, a thermal transfer gas is led into a cavity 46 in the surface of the pedestal 16 in back of the wafer 18. In practice, the cavity 46 is formed in a spiral or tree-like pattern to uniformly distribute the thermal transfer gas across the back side of the wafer 16 while still providing a substantially planar surface on the top of the pedestal 16. A pressure-regulated valve 48 maintains the pressure of the thermal transfer gas in the cavity 46 at a sufficiently high pressure, for example, 6 to 8 Torr to promote effective convective thermal transfer between the wafer 18 and the pedestal 16 through the thermal transfer gas. Note that the thermal gas does not act convey heat into or out of the pedestal 16, and a closed circulation path is not typical.

The backside gas pressure is substantially higher than the plasma chamber pressure, so that the wafer tends to bow outwardly. An electrostatic chuck embedded in the pedestal 16 may be used to fairly uniformly attract the wafer 18 to the pedestal to overcome the pressure differential. Alternatively, a ring clamp may press or mechanically chuck the circumferential periphery of the wafer 18 against the pedestal 16 to thereby seal the edge of the wafer 18. The center of the wafer 18 may still bow, but the controlled bowing may be compensated by forming the top of the pedestal 16 as a dome having the same curvature. It is of course understood that under these situations a very thin layer of thermal transfer gas may exist between the substantially planar top of the pedestal 16 and the wafer 18, with such a thin layer providing very effective convective thermal transfer.

Neither of the described chucking techniques typically employs a separate elastic vacuum seal at the wafer periphery where the wafer rests directly on the pedestal outside of the transfer gas cavity. As a result, the vacuum seal is not perfect, and a substantial amount of thermal transfer gas typically leaks into the plasma chamber. Therefore, it is desired that the thermal transfer gas be a noble gas so as to not react with the sputtered particles. Helium is the preferred thermal transfer gas for etching and CVD because its smaller atomic weight is more effective in convective heat transfer. However, since argon is already used as the sputtering working gas, argon is typically also used as the thermal transfer gas in a sputter reactor. Only one gas supply is needed, and any leakage of thermal transfer gas into the main chamber does not affect the plasma physics involved in the sputtering. Any pressure change resulting from the leakage of the thermal transfer gas can be compensated by decreasing the supply of the working gas through its valve 26 or increasing the pumping speed of the pump 28.

There has been much recent interest in sputtering at minimum pressures of about 1 milliTorr or somewhat less. Generally, at even lower pressures, the reactor will not support a plasma. Various techniques are available for producing a more anisotropic sputtering flux. However, a high chamber pressure increases the probability that the anisotropic particle flux will be randomized by scattering from the working gas.
Another technique for achieving anisotropic sputtering flux is to generate a high-density plasma in the sputter reactor. This tends to produce a high fraction of ionized sputtered atoms. An RF power supply 50 coupled to the pedestal 16 through a DC blocking capacitor 52 induces a negative DC self bias on the pedestal 16 and draws the ionized sputtered particles perpendicular towards the wafer 18 and deep within any via hole to be filled. Often though, the pedestal 16 is left electrically floating, but sufficient negative self-bias appears on the pedestal 16 to still draw the positively charged ions. In either case, however, a high operating pressure introduces scattering which both randomizes the flux and tends to neutralize the sputtered ions. Another technique for increasing the anisotropy is long-throw sputtering. In this technique, the target and wafer are separated by a longer distance or collimators interposed between the target and wafer to absorb off angle sputtered particles.

The ultimate in low-pressure sputtering, particularly applicable to copper, is sustained self-sputtering (SSS). With the combination of a sufficiently high-plasma density and a proper sputtering material, the ionization density of the sputtered atoms is high enough that they serve the role of the working gas (argon) ions, and no separate working gas is required. Once the plasma has been ignited, the supply of argon can be stopped, but the plasma sputtering of the target is sustained as the target ions self-sputters yet more target ions. Only a few elements have a satisfactorily high cross section to enable sustained self-sputtering. Copper is the most important of these at the present time. Aluminum cannot sustain self-sputtering.

A number of features can be employed to facilitate sustained self-sputtering, as Fu et al. describe in U.S. Patent Application, Serial No. 08/854,008, incorporated herein in its entirety. The target power should be high. The magnetron should be small so that the target power density is very high. The magnetron should have asymmetric magnetic poles, one enclosing the other, with more magnetic strength in the outer pole. Fu discloses a several advantageous magnetron designs in U.S. Patent Application, Serial No. 09\249,468, filed February 12, 1999. A biased grid or wafer ring may be used to extend the plasma closer to the wafer. With these features, a sufficiently high plasma density can be achieved without the use of supplemental RF inductive power coupling.

The same features which promote SSS are effective at achieving a higher-density plasma with target materials not susceptible to SSS. As a result, argon or other working gas is still required, but sufficient self-sputtering is occurring that the amount of argon can be reduced and the minimum chamber pressure for maintaining a plasma is reduced. Alternatively, these self-sputtering features increase the sputtering ionization fraction of non-SSS materials, thereby promoting deep hole filling with an externally biased or self-biased pedestal.

The invention may be summarized as using either helium or neon, preferably helium, as the backside thermal transfer gas during sputtering. The use is particularly advantageous when the sputtering is performed at low-pressure or is self-sustained sputtering, for example, of copper.

For low-pressure sputtering, a working gas such as argon may be initially supplied into the vacuum chamber to strike the plasma, but thereafter its supply is reduced. For low-pressure sputtering, some working gas may be supplied directly into the chamber.

The invention may be put into practice in a number of ways, and one embodiment will now be described by way of example only and with refrence to the following drawings, in which:

FIG. 1 is a schematic view, partially in cross section, of a plasma sputter reactor incorporating many features of the prior art and of sustained self-sputtering.

FIG. 2 is a schematic view, partially in cross section, of a plasma sputter reactor operated according to the invention.

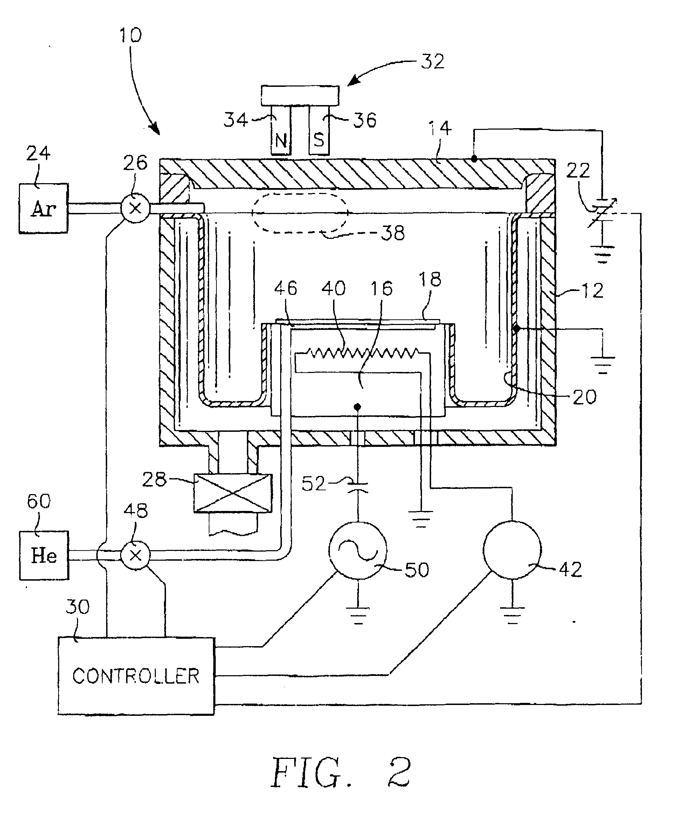

In sustained self-sputtering or low-pressure sputtering, it is advantageous to replace argon with helium (He) as the thermal transfer gas used in backside cooling. As illustrated schematically in FIG. 2, a source 50 of helium is provided in the gas panel of the processing system. The flow of helium is then metered through the pressure-regulated valve 48 and supplied to the cavity 46 at the top of the pedestal 16 to provide convective thermal transfer between the wafer 18 and the temperature-controlled pedestal 16. As mentioned before, the pedestal may include the illustrated resistive heater 40, an unillustrated channel for a cooling fluid, or both. Helium, of course, is already available in most fabrication facilities because of its use in backside cooling for etching and CVD.

The substitution of helium for argon as the thermal transfer gas has several advantages, most of which arise from its lighter mass. The atomic weight (AW) is presented in TABLE 1 for several noble gases and atoms of several sputtering materials.

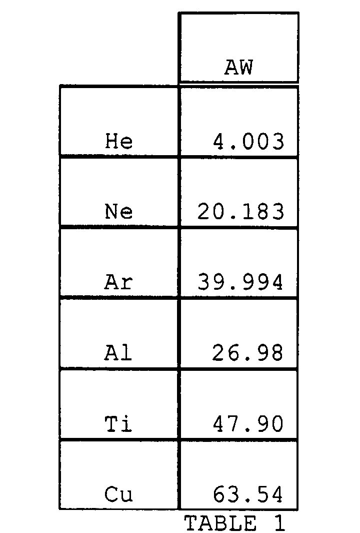

Since helium is much lighter than argon, it is more efficient in convective heat transfer, thereby permitting lower pressure of the thermal transfer gas in the cavity. The lower pressure reduces leakage into the chamber and also reduces the bowing of the wafer. Alternatively, the more efficient heat transfer promotes lower thermal differentials between the wafer 18 and the pedestal 16, thus promoting temperature control over the wafer area and over time as chamber temperatures change during the processing cycle.

Whatever helium does leak into the sputtering chamber has reduced effect upon the sputtering process. Even disregarding atomic collision cross sections, the lighter mass of helium relative to the sputtered atoms means there is less deflection of sputtered atom trajectories since the momentum transfer between two scattered atoms is decreased as their mass ratio departs from unity. Therefore, the sputtering flux profile obtained by sputtering ionization, collimation, or other means is less degraded by a certain pressure of helium compared to argon.

Also, helium has a higher ionization energy (24.6eV) than does argon (15.8eV). Therefore, collisions of ionized sputtered metal ions with neutral helium is much less likely to result in the sputtered metal becoming neutralized.

The lighter mass of helium also promotes self-sputtering of copper and to a lesser extent of titanium, both of processes rely upon the sputtered particle being ionized. While helium does become ionized in the plasma and hence is likely to strike the target, it will do so at reduced kinetic energy relative to argon. The momentum of helium is so much lower that the helium is unlikely to sputter any target atoms. However, the mass of argon is only somewhat less than copper so that argon is more likely to sputter the copper target but not with as high an energy as copper ions.

As has been described by Leiphart, helium is also effective at maintaining a plasma at lower pressures because it generates more secondary electrons than does argon.

Neon is another noble gas providing better backside cooling than argon. It has advantageously smaller mass and lower ionization energy than argon, but not as small as the values for helium.

Although the helium is most useful as the thermal transfer gas when sustained self-sputtering is used for copper deposition, it is also useful when argon continues to be supplied to maintain a low but significant pressure, for example, in low-pressure sputtering of aluminum, titanium, or tantalum. The low-pressure plasma may depend upon partial self-sputtering of the target for continued support of the plasma at the low pressure. For sustained self-sputtering, it is generally necessary to initially supply argon to strike the plasma. Thereafter, the argon supply is substantially eliminated. For low-pressure sputtering, it may be necessary to initially supply a greater pressure of argon for plasma striking and thereafter reduce the argon supply to achieve the desired lower pressure. The use of helium may be advantageously extended to higher sputtering pressures since it is more effective for convective heat transfer. It may also be possible to strike the plasma with only helium supplied from the working gas source 24, and thereafter to rely more on self-sputtering to increase the plasma density. This would simplify the gas supply.

The invention thus provides more efficient thermal contact while improving the sputtering characteristics, particularly in sustained self-sputtering, partially sustained self-sputtering, and low-pressure sputtering. Nonetheless, it can use a gas that is readily available and already used for other applications.

## Claims

1. A method of sputtering in a plasma chamber, comprising:
supporting a substrate to be wafer deposited on a surface of a pedestal including a cavity formed in said surface;
applying a power to a target comprising a material to be sputter deposited on the substrate by a plasma sputtering process;
controlling a temperature of the pedestal; and
supplying a thermal transfer gas comprising at least one of helium and neon to said cavity while said substrate is supported on the surface of the pedestal.

2. The method of Claim 1, wherein said thermal transfer gas comprises helium.

3. The method of Claim 1 or claim 2, further comprising:
supplying argon to said chamber and striking a plasma of said argon in said chamber; and
then reducing a supply of said argon but maintaining said plasma.

4. The method of Claim 3, wherein said reducing step stops a flow of said argon

5. The method of any preceding claim, wherein said target comprises copper for depositing a copper layer on the substrate.

6. The method of any of claims 1 to 4, wherein said target comprises aluminum.

7. The method of any preceding claim, further comprising maintaining a pressure of less than 1 milliTorr in said chamber during said plasma sputtering process.

8. The method of any preceding claim, wherein said power is DC power.

9. A sputtering apparatus, comprising:
a vacuum chamber;
a source of argon to be delivered into said chamber;
a target comprising a material to be sputtered ;
a power supply connected to said target;
a pedestal for supporting on a surface thereof a substrate to be sputter deposited and including a cavity in said surface; and
a source of one of helium and neon to be delivered to said cavity.

10. The apparatus of Claim 9, wherein said source delivers helium to said cavity.

11. The apparatus of Claim 9 or Claim 10, wherein said power supply is a DC power supply.

12. The apparatus of Claim 9, Claim 10 or claim 11, wherein said target is a copper target.

13. The apparatus of Claim 12, further comprising a magnetron positioned at a back of said target and capable of supporting a sustained self-sputtering plasma in said chamber.
